# EUROPÄISCHE PATENTANMELDUNG

(11) **EP 2 388 563 A2**
(43) Veröffentlichungstag der Anmeldung: **23.11.2011**
(21) Anmeldenummer: 11162000.1
(22) Anmeldetag: 12.04.2011
(51) Int. Cl.: G01K 7/16

(54) **Verfahren zur Ermittlung der Temperatur eines Leistungshalbleiters**

(30) Priorität: 20.05.2010 DE 102010029147
(71) Anmelder: SEMIKRON Elektronik GmbH & Co. KG, 90431 Nürnberg (DE)
(72) Erfinder: Schuler, Stefan, 91052, Erlangen (DE)

(57) **Zusammenfassung**

Bei einem Verfahren zur Ermittlung der Temperatur (T) eines Leistungshalbleiters (12), bei dem ein erster Steuerkontakt (22a) an einen ersten Pol eines im Leistungshalbleiter (12) integrierten Vorwiderstandes (14) angeschlossen ist, wobei ein zum Leistungshalbleiter (12) weiterführender zweiter Pol des Vorwiderstandes (14) zu einem zweiten Steuerkontakt (22b) geführt ist:
- werden erster (22a) und zweiter Steuerkontakt (22b) über je einen Bonddraht (16) mit einer ersten (24a) und zweiten Anschlussklemme (24b) verbunden,
- wird durch eine elektrische Messung zwischen beiden Anschlussklemmen (24a,b) der Widerstandswert (Rᵥ) des Vorwiderstandes (14) ermittelt,
- wird anhand des Widerstandwertes (Rᵥ) und einer Temperatur-Widerstands-Kennlinie (26) des Vorwiderstandes (14) die Temperatur (T) des Vorwiderstandes (14) als Temperatur des Leistungshalbleiters (12) ermittelt.

## Beschreibung

Die Erfindung betrifft ein Verfahren zur Ermittlung der Temperatur eines Leistungshalbleiters.

Integrierte Halbleiterbauelemente werden als sogenannte Halbleiterchips oder kurz Chips in der Regel aus einem Grundsubstrat, z.B. einem Siliziumwafer, durch Prozessschritte hergestellt. Auch Leistungshalbleiter, z.B. IGBTs, werden als derartige Chips hergestellt.

Ein Leistungshalbleiter weist in der Regel einen Steuerkontakt auf, über den dieser angesteuert wird. Z.B. bei einem IGBT ist dies das Gate, über welches ein Schaltvorgang im IGBT ausgelöst wird. Es sind Leistungshalbleiter mit integriertem Vorwiderstand bekannt. Der Vorwiderstand ist dann im Inneren des Leistungshalbleiters in Reihe zum Steuerkontakt geschaltet.

Die Ansteuerung erfolgt hier nach wie vor über den Steuerkontakt. Der interne, auf den jeweiligen Leistungshalbleiter abgestimmte Gatewiderstand soll z.B. verschieden ausgebildete bzw. ausgeprägte Miller-Plateaus kompensieren und ein gleichmäßigeres Schalten des Leistungshalbleiters bewirken.

Es sind auch Leistungshalbleiter neuerer Generation bekannt, die neben dem genannten ersten Steuerkontakt einen zweiten Kontakt, d.h. auf dem Chip ein meist kleineres Kontaktfenster bzw. sogenanntes Hilfsfenster aufweisen. Dieses Hilfsfenster steht in direktem Kontakt zum eigentlichen internen Steuerkontakt bzw. Steueranschluss im Leistungshalbleiter und umgeht dadurch den Vorwiderstand.

Mit anderen Worten befindet sich dann der im Chip integrierte Widerstand zwischen beiden Steuerkontakten. Der erste Pol des Widerstands ist also mit dem ersten Steuerkontakt, sein zweiter Pol mit dem zweiten Steuerkontakt verbunden. Der interne Gatewiderstand hat unter Normalbedingungen beispielsweise einen Widerstandswert von ca. 10Ω. Üblicherweise wird immer nur das als Hauptfenster bezeichnete Kontaktfenster des ersten Steuerkontakts auf einem solchen Chip gebondet bzw. kontaktiert. Der Vorwiderstand selbst ist bezüglich einer Kontaktierung unzugänglich, da er sich im Inneren des Leistungshalbleiters befindet.

Für die Lebensdauer eines solchen Leistungshalbleiters ist insbesondere der Temperaturstress bzw. die Temperaturbelastung entscheidend, welche dieser im Verlauf der Betriebszeit erfährt. Entscheidend, vor allem in Leistungshalbleiterschaltern, ist hierbei die sogenannte Sperrschichttemperatur. Erstrebenswert ist es, die Sperrschichttemperatur eines Leistungshalbleiters während dessen Betriebs möglichst genau zu verfolgen; so wird z.B. eine grobe Abschätzung der zu erwartenden Restlebensdauer des Chips möglich. Ein Austausch kann dann noch rechtzeitig und geplant erfolgen, bevor ein Ausfall des Chips zu erwarten ist.

Bekannt ist, den Halbleiterchip auf einem Substrat anzuordnen und möglichst nahe am Halbleiterchip einen herkömmlichen Temperatursensor aufzubringen, z.B. in Form eines NTC-(negative temperature coefficient)-Widerstandes. Der Sensor erfasst die Temperatur des Substrats und damit indirekt bzw. sehr überschlägig die Temperatur des Chips und damit die Sperrschichttemperatur. Hier sind allerdings Temperaturdifferenzen von etwa bis zu 80°C zwischen tatsächlicher Sperrschichttemperatur und gemessener Temperatur zu erwarten.

Auch ist es bekannt, auf dem Chip selbst, z.B. auf dessen Vergussgehäuse einen Thermosensor aufzubringen, z.B. in Form eines Thermoelementes. Die Temperaturerfassung erfolgt näher am eigentlichen Chip bzw. der Sperrschicht. Auch hier erfolgt jedoch nur eine ungenaue Erfassung der Sperrschichttemperatur mit Differenzen von etwa bis zu 20°C. Die Erfassung der Temperatur durch ein Thermoelement ist z.B. aus der DE 10 2009 045 068.8 (noch nicht veröffentlicht, Anmeldetag: 28.09.2009, unser Zeichen: SE/P090076DE01) bekannt.

Insgesamt findet also keine zufriedenstellende Erfassung der aktuellen Temperatur bzw. Sperrschichttemperatur eines Leistungshalbleiters statt. Bisher ist daher keine hinreichend genaue Beurteilung des Stresszustandes, und damit Lebensdaueraussagen bzw. -prognosen oder ähnliches für einen Leistungshalbleiter hinreichend genau möglich.

Aufgabe der Erfindung ist es, ein verbessertes Verfahren zur Ermittlung der Temperatur eines Leistungshalbleiters anzugeben.

Die Aufgabe wird gelöst durch ein Verfahren gemäß Patentanspruch 1.

Die Erfindung beruht auf der Erkenntnis, dass der integrierte Gatewiderstand besonders nahe der Sperrschicht liegt und temperaturabhängig ist. Dessen Widerstandswert hängt damit von der tatsächlich internen Temperatur im Chip ab.

Die Erfindung beruht auf der Idee, dass bei einem als Chip ausgeführten Leistungshalbleiter auch der zweite Steuerkontakt mit Hilfe eines Bonddrahtes anschließbar ist, um hier zusammen mit einem Bonding des ersten Steuerkontakts einen direkten beiderseitigen elektrischen Zugang zum internen Gatewiderstand zu schaffen. Beide Anschlüsse des internen Widerstandes können also durch elektrische Kontakte zugänglich gemacht werden. Da der interne Gatewiderstand temperaturabhängig ist, kann hier über diesen indirekt eine Temperaturerfassung stattfinden. Das sogenannte Hilfsfenster auf dem Chip, das den zweiten Steuerkontakt bildet, ist von seiner Geometrie her in der Regel ausreichend, um es bonden zu können, z.B. mit einem Bonddraht von 75µm Durchmesser.

Gemäß der Erfindung wird daher der erste und zweite Steuerkontakt des Chips über je einem Bonddraht mit einer ersten und zweiten Anschlussklemme verbunden, also gebondet. Erst die Anschlussklemmen sind dann von außen durch weitere elektrische Beschaltung bzw. Kontaktierung zugänglich. Erfindungsgemäß wird durch eine elektrische Messung zwischen beiden Anschlussklemmen der Widerstandswert des Vorwiderstandes ermittelt. Anhand des Widerstandswertes und einer Temperatur-Widerstands-Kennlinie des Vorwiderstandes wird anschließend die Temperatur des Vorwiderstandes als Temperatur des Leistungshalbleiters ermittelt.

Erfindungsgemäß wird über die Anschlussdrähte und die Anschlussklemmen ein elektrischer beidseitiger Zugang zum Widerstand geschaffen. Die Abhängigkeit des chipinternen integrierten Vorwiderstandes von der Temperatur ist proportional zur reziproken Beweglichkeit der Ladungsträger. Die Beweglichkeit nimmt mit steigender Temperatur ab, damit nimmt der Widerstand mit steigender Temperatur zu. Zur Auswertung des Widerstandes müssen Strom und Spannung am internen Gatewiderstand gemessen werden. Strom und Spannung können dann einfach in einen äquivalenten Widerstandswert und über die Kennlinie in einen Temperaturwert umgerechnet werden.

Ein messbarer Stromfluss liegt im Vorwiderstand nur dann vor, wenn ein Schaltstrom dem ersten Steuerkontakt zu- oder abgeführt wird; also z.B. nur während des Ein- oder Ausschaltvorganges eines IGBT. In einer ersten Ausführungsform der Erfindung erfolgt die Messung daher während der betriebsbedingten Bestromung des ersten Steuerkontaktes mit einem Betriebsstrom. Mit anderen Worten wird der Betriebsstrom als Messstrom benutzt. In der ersten Ausführungsform der Erfindung wird daher der Betriebsstrom gemessen und gleichzeitig die Spannung über dem Vorwiderstand ermittelt.

In einer alternativen Ausführungsform wird die Messung durch einen über beide Steuerkontakte explizit zugeführten Messstrom durchgeführt. Hierzu kann auch z.B. ein weiterer, in der Regel höherohmiger Widerstand mit dem zweiten Steuerkontakt verbunden, beispielsweise ein entsprechender Widerstand an das Hilfsfenster kontaktiert werden. Über eine geringe Potentialdifferenz kann dann ein geringer Hilfsstrom bzw. Messstrom zu einem beliebigen Zeitpunkt im Vorwiderstand erzeugt werden und hier die Messung des aktuellen Widerstandswertes erfolgen. Die Temperaturmessung ist dann z.B. nicht an die Schaltvorgänge im IGBT gekoppelt.

In einer weiteren Ausführungsform der Erfindung wird die Kennlinie anhand einer Kalibrierprozedur am Leistungshalbleiter ermittelt. Dies kann z.B. für jeden einzelnen Chip, eine Chipserie oder einen Chiptyp erfolgen. Z.B. kann vor der ersten Inbetriebnahme eines Leistungshalbleiters eine automatische Kalibrierung stattfinden, während der eine spezielle Kennlinie ermittelt wird. Die Kennlinie kann dann für diesen Chip fest und dauerhaft abspeichert werden, um sie im Verfahren verwenden zu können.

In einer bevorzugten Ausführungsform ist der Chip auf einer Trägerplatine (DCB, Direct Copper Bonding) montiert, welche außerdem einen o.g. eigenen Temperatursensor aufweist. Die Kennlinie kann dann im Leerlauf des Leistungshalbleiters unter zu Hilfenahme des Temperatursensors ermittelt werden. Da im Rahmen der Kalibrierprozedur ein Temperaturgleichgewicht zwischen Chip und Temperatursensor gewährleistbar ist, bzw. hier unter Umständen eine in diesem Fall bekannte Differenztemperatur herrscht, kann über den Temperatursensor der Trägerplatine eine genaue Temperaturkalibrierung stattfinden. Da insbesondere sich der Chip im Leerlauf befindet, entstehen keine thermischen lokalen Störungen, wie z.B. beim Betrieb des Chips, wenn dieser also beispielsweise durch einen Laststrom Abwärme produziert, diese sich jedoch lokal nur im Chip und nicht am Temperatursensor wiederspiegelt.

Mit anderen Worten: Ist der Chip auf einer Platine montiert und besitzt diese einen herkömmlichen Temperatursensor, z.B. den o.g. NTC, kann bei Leerlauf des Chips für die tatsächliche Widerstandstemperatur die NTC-Temperatur als Referenz verwendet werden.

Bekannte Chips in Form von IGBTs weisen heute einen einzigen internen Gate- bzw. Vorwiderstand auf. Im Hinblick auf neuere Entwicklungen sind aber auch Chips mit mehreren internen Vorwiderständen denkbar. Alternativ ist eine Parallelschaltung mehrerer IGBTS denkbar; auch so entsteht eine Anordnung mit mehreren internen Vorwiderständen. In diesen und anderen vergleichbaren Situationen entsteht eine Struktur mit mehreren Vorwiderständen, die untereinander thermisch gekoppelt sind und von denen jeder einzelne zur erfindungsgemäßen Temperaturmessung herangezogen werden kann.

In einer vorteilhaften Ausführungsform weisen ein oder mehrere eben genannte Leistungshalbleiter bzw. Chips mehrere Vorwiderstände mit zwei jeweiligen Steuerkontakten auf. Das Verfahren wird dann an demjenigen der Vorwiderstände durchgeführt, von dem bekannt ist, dass er für die gewünschte Messung die beste Ausgangsposition bietet: z.B. für eine Lebensdauerermittlung wird derjenige gewählt, für den bekannt ist, dass er aufgrund seiner Positionierung thermisch am meisten beansprucht ist. Mit anderen Worten wird also für einen Chip mit mehreren Vorwiderständen lediglich der thermisch am meisten belastete Vorwiderstand ausgewertet, um so die maximale Temperaturbelastung des Chips zu ermitteln. So wird z.B. eine "worst case"-Auswertung der Temperatur in Bezug auf Lebensdauerabschätzung usw. möglich.

In einer alternativen Ausführungsform, bei der der Leistungshalbleiter wie eben ausgeführt, ebenfalls mehrere Vorwiderstände mit jeweiligen Steuerkontakten aufweist, wird das Verfahren an mehreren oder allen der Vorwiderstände durchgeführt. Z.B. könnte durch eine Reihenschaltung mehrerer oder aller Vorwiderstände eine mittlere Temperatur aller entsprechenden Messstellen ermittelt werden. Alternativ kann z.B. auch eine jeweilige Einzelmessung stattfinden und eine nachträgliche Auswahl bzw. Mittelung verschiedener ermittelter Temperaturen einzelner Vorwiderstände stattfinden.

Für eine weitere Beschreibung der Erfindung wird auf die Ausführungsbeispiele der Zeichnungen verwiesen. Es zeigen, jeweils in einer schematischen Prinzipskizze:
- Fig.1: einen als Chip ausgeführten Leistungshalbleiter in Draufsicht,
- Fig.2: die Widerstands-Temperatur-Kennlinie des Leistungshalbleiters aus Fig.1,
- Fig.3: einen alternativen Leistungshalbleiter in perspektivischer Darstellung.

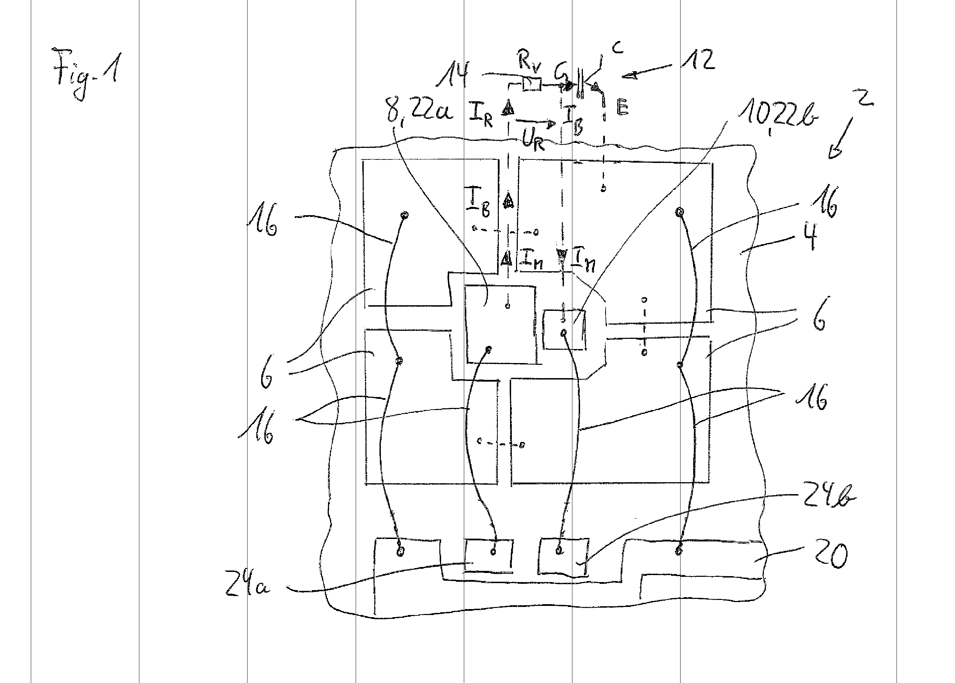

Fig. 1 zeigt einen Leistungshalbleiter in Form eines IGBT, der integriert als Chip 2 ausgeführt ist. Fig. 1 zeigt den Chip 2 in Draufsicht, d.h. einen Ausschnitt von dessen Oberseite 4. Auf der Oberseite 4 sind zu kontaktierende Fenster in Form einer auf dem prozessierten Siliziumsubstrat angeordneten Metallisierungsoberflächen zu sehen, nämlich vier Emitterfenster 6 sowie ein Gatefenster 8 und ein Hilfsfenster 10.

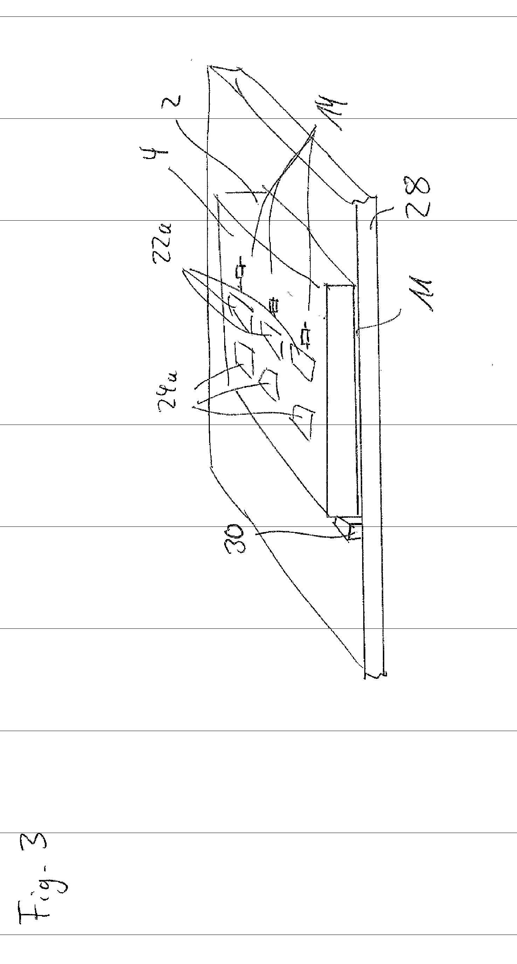

Die chipinterne Beschaltung ist in Fig. 1 gestrichelt angedeutet: Der eigentliche Leistungshalbleiter 12 also der IGBT als integrierte Halbleiterstruktur, ist mit seinem Emitter E auf die vier Emitterfenster 6 parallel geschaltet. Der Kollektor C führt zur in Fig. 1 nicht sichtbaren Chipunterseite in Form einer ganzflächigen Metallisierung als Kollektoranschluss 11. (siehe Fig.3). Das Gate G des Leistungshalbleiters 12 ist direkt mit dem Hilfsfenster 10 kontaktiert. Über einen chipinternen Vorwiderstand 14 mit dem Widerstandswert Rᵥ ist das Gate G mit dem Gatefenster 8 verbunden.

Der Chip 2 an sich kann nicht direkt kontaktiert, z.B. verlötet werden. Hierzu muss zunächst ein sogenanntes Bonding stattfinden: Zur Kontaktierung des Leistungshalbleiters 12 sind die Emitterfenster 6 mit Hilfe von Bonddrähten 16 auf eine Emitteranschlussklemme 20 geführt. Der Kollektor C ist über den Kollektoranschluss 11 direkt lötbar. Z.B. ist die Chipunterseite flächig verlötet. Das Gatefenster 8 als erster Steuerkontakt 22a des Chips 2 ist ebenfalls über einen Bonddraht 16 auf eine erste Gate-Anschlussklemme 24a geführt. Die Beschaltung bzw. elektrische Ansteuerung des Leistungshalbleiters 12 im Betrieb erfolgt damit über den Kollektoranschluss 11 sowie die Anschlussklemmen 20 und 24a. Das Hilfsfenster 10 wird gemäß Stand der Technik nicht benutzt.

Erfindungsgemäß ist das Hilfsfenster 10 als zweiter Steuerkontakt 22b auf eine zweite Gate-Anschlussklemme 24b geführt. Erfindungsgemäß erfolgt nun an den Anschlussklemmen 24a,b eine Messung der über dem Vorwiderstand 14 abfallenden Spannung U_{R} sowie des durch diesen fließenden Stroms I_{R}. Aus diesen beiden Größen lässt sich der Wert Rᵥ des Vorwiderstandes 14 ermitteln.

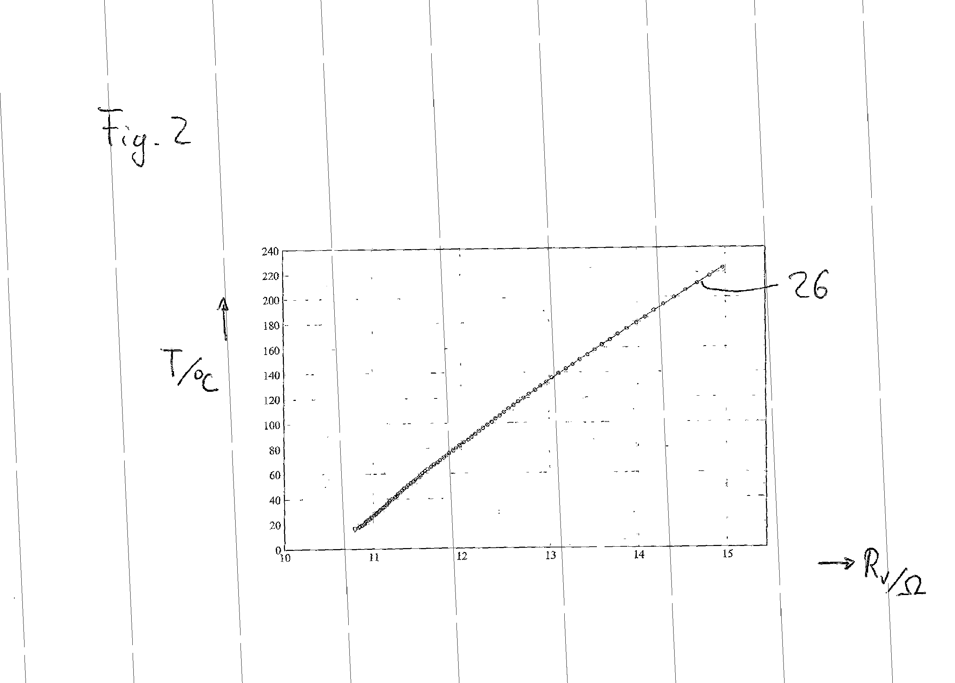

Fig. 2 zeigt eine für den Vorwiderstand 14 geltende Kennlinie 26, die dessen Zusammenhang zwischen dem Widerstandswert Rᵥ in Ohm und der Temperatur in °C des Vorwiderstandes 14 wiedergibt. Die Temperatur des Vorwiderstandes 14 ist hierbei gleichzusetzen mit der Temperatur des Chips 2 bzw. des Leistungshalbleiters 12, insbesondere im Fall eines IGBT mit dessen Sperrschichttemperatur, da der Vorwiderstand 14 sich ebenfalls integriert im gleichen Halbleitersubstrat befindet und somit nahezu von thermischer Gleichheit zwischen diesen jeweiligen Komponenten des Chips 2 auszugehen ist. Erfindungsgemäß wird daher über die Kennlinie 26 und den aus der Spannung U_{R} und dem Strom I_{R} ermittelten Widerstandswert Rᵥ die Temperatur des Leistungshalbleiters 12 ermittelt.

In einer ersten Ausführungsform ist hierbei der Strom I_{R} derjenige Betriebsstrom I_{B}, der während eines Schaltvorgangs am Leistungshalbleiter 12 fließt. Der Strom I_{R} fließt damit ausschließlich über die Anschlussklemme 24a in den Vorwiderstand 14 und von dort in das Gate G des Leistungshalbleiters 12. An der Anschlussklemme 24b wird kein Stromfluss gemessen, sondern nur stromlos (abgesehen von einem eventuellen minimalen Messgerätestrom) die Spannung U_{R}.

In einer alternativen Ausführungsform hingegen fließt kein Strom in das Gate G des Leistungshalbleiters 12, da dieser sich gerade nicht in einem Schaltvorgang befindet. Es wird dann alternativ zu oben ein Stromkreis über die Anschlussklemme 24a den Vorwiderstand 14 und die Anschlussklemme 24b gebildet, welcher vom Strom I_{R} durchflossen ist. I_{R} ist dann im Gegensatz zum oben genannten Schaltstrom ein reiner Messstrom IM. Die Spannung U_{R} wird dabei in gleicher Weise zwischen den Anschlussklemmen 24a,b ermittelt.

In einer weiteren Ausführungsform wird vorab die Kennlinie 26 in einer Kalibrierprozedur 2 ermittelt, in dem der Chip 2 z.B. in einem Thermoschrank auf bestimmte Temperaturen erhitzt wird, wobei die Temperatur T z.B. aufgrund einer Messung im Thermoschrank bekannt ist, und dann der Widerstandswert Rᵥ zur bekannten Temperatur T ermittelt wird.

Fig.3 zeigt eine alternative Ausführungsform, bei der der Chip 2 auf einer Trägerplatine 28 montiert ist, in dem dessen Kollektoranschluss 11 mit dieser verlötet ist. Direkt neben dem Chip ist auf der Trägerplatine 28 außerdem ein Temperatursensor 30 montiert. Die Kennlinie 26 wird dann alternativ derart ermittelt, dass die gesamte Anordnung aus Trägerplatine 28 und Chip 2 aufgeheizt wird, wobei die Temperatur jeweils durch den Temperatursensor 30 ermittelt wird. Durch die oben beschriebene Messung der Spannung U_{R} und des Stromes I_{R} wird dann wieder der zugehörige Widerstand Rᵥ bestimmt. Diese Messung findet insbesondere im Leerlauf des Leistungshalbleiters 12 statt, wenn also dessen Kollektor C und Emitter E nicht bestromt und spannungsfrei sind. So ist sichergestellt, dass intern im Chip 2 keine zusätzlich erzeugte Abwärme entsteht und die Temperaturmessung des Temperatursensors 30 genaue Ergebnisse liefert.

Fig. 3 zeigt außerdem eine Ausführungsform eines Chips 2 bzw. eines Leistungshalbleiters 12, der intern mehrere Vorwiderstände 14 und zugänglich mehrere jeweils daran angeschlossene Steuerkontakte 22a,b (teils nicht dargestellt) sowie Anschlussklemmen 24a,b (teils nicht dargestellt) aufweist. In einer ersten Ausführungsform wird das oben beschriebene Verfahren lediglich an dem am meisten thermisch beanspruchten der gezeigten Vorwiderstände 14 durchgeführt.

In einer alternativen Ausführungsform des Verfahrens wird dieses an mehreren oder allen Vorwiderständen 14 durchgeführt, wobei eine jeweilige Auswahl bzw. Mitteilung der gegebenenfalls verschiedenen Temperaturen stattfindet um die jeweilige Temperatur des Leistungshalbleiters 12 möglichst genau zu ermitteln.

## Patentansprüche

1. Verfahren zur Ermittlung der Temperatur (T) eines Leistungshalbleiters (12), bei dem ein erster Steuerkontakt (22a) an einen ersten Pol eines im Leistungshalbleiter (12) integrierten Vorwiderstandes (14) angeschlossen ist, wobei ein zum Leistungshalbleiter (12) weiterführender zweiter Pol des Vorwiderstandes (14) zu einem zweiten Steuerkontakt (22b) geführt ist, bei dem:
- erster (22a) und zweiter Steuerkontakt (22b) über je einen Bonddraht (16) mit einer ersten (24a) und zweiten Anschlussklemme (24b) verbunden werden,
- durch eine elektrische Messung zwischen beiden Anschlussklemmen (24a,b) der Widerstandswert (Rᵥ) des Vorwiderstandes (14) ermittelt wird,
- anhand des Widerstandwertes (Rᵥ) und einer Temperatur-Widerstands-Kennlinie (26) des Vorwiderstandes (14) die Temperatur (T) des Vorwiderstandes (14) als Temperatur des Leistungshalbleiters (12) ermittelt wird.

2. Verfahren nach Anspruch 1, bei dem die Messung während einer betriebsbedingter Bestromung des ersten Steuerkontaktes (22a) mit einem Betriebsstrom (I_{B}) erfolgt.

3. Verfahren nach einem der vorhergehenden Ansprüche, bei dem die Messung mit Hilfe eines über beide Steuerkontakte (22a,b) zugeführten Messtromes (IM) erfolgt.

4. Verfahren nach einem der vorhergehenden Ansprüche, bei dem die Kennlinie (26) anhand einer Kalibrierprozedur am Leistungshalbleiter (12) ermittelt wird.

5. Verfahren nach einem der vorhergehenden Ansprüche, wobei der Leistungshalbleiter (12) auf einer Trägerplatine (28) mit integriertem Temperatursensor (30) montiert ist, bei dem die Kennlinie (26) im Leerlauf des Leistungshalbleiters (12) unter Zuhilfenahme des Temperatursensors (30) ermittelt wird.

6. Verfahren nach einem der vorhergehenden Ansprüche, wobei der Leistungshalbleiter (12) mehrere Vorwiderstände (14) mit jeweiligen Steuerkontakten (22a,b) aufweist, bei dem das Verfahren am thermisch am meisten beanspruchten der Vorwiderstände (14) durchgeführt wird.

7. Verfahren nach einem der vorhergehenden Ansprüche, wobei der Leistungshalbleiter (12) mehrere Vorwiderstände (14) mit jeweiligen Steuerkontakten (22a,b) aufweist, bei dem das Verfahren an mehreren oder allen der Vorwiderstände (14) durchgeführt wird.
